# EUROPEAN PATENT APPLICATION

(11) **EP 4 447 121 A1**
(43) Date of publication of application: **16.10.2024**
(21) Application number: 23167839.2
(22) Date of filing: 13.04.2023
(51) Int. Cl.: H01L 29/423, H01L 29/78, H01L 21/336

(54) **TRENCH-GATE-TYPE FIELD EFFECT TRANSISTOR DEVICE AND METHOD OF MANUFACTURING**

(71) Applicant: Nio Technology (Anhui) Co., Ltd, Hefei City, Anhui 230601 (CN)
(72) Inventor: NGWENDSON, Luther-King, Oxford (GB); LONG, Hongyao, Oxford (GB); SURESH, Vinay, Oxford (GB)
(74) Representative: Vossius & Partner Patentanwälte Rechtsanwälte mbB

(57) **Abstract**

The present disclosure relates to a transistor device (10) which includes a main body (12) made of silicon carbide, two gate trenches (14A, 14B) extending into the main body (12). Each gate trench (14A, 14B) has a floor section (20) and side wall sections (22A, 22B) which each have a lower portion (26) and an upper portion (28). The transistor device (10) further includes a layer of dielectric material (32) covering the floor section (20) and the side wall sections (22A, 22B). A reduced thickness section (36) of the layer of dielectric material (32) is provided on the side wall section of the first gate trench which is arranged towards a second gate trench of the gate trenches (14A, 14B) adjacent to the first gate trench. The reduced thickness section (36) extends along the upper portion (28) of the side wall section of the first gate trench. The present disclosure also relates to a method of manufacturing a transistor device (10).

## Description

A field effect transistor, also referred to as FET, is a type of transistor that uses an electric field to control the flow of current in a semiconductor and has been applied for many years. FETs generally include a plurality of terminals, which generally include a source, a gate, and a drain. FETs control the flow of current by the application of a voltage to the gate, which in turn alters the conductivity between the drain and source.

FETs use either electrons, referred to as an n-channel, or holes, referred to as a p-channel, as charge carriers in their operation. The most widely used field effect transistor is the MOSFET (metal oxide semiconductor field effect transistor), though several different types of field effect transistors exist.

Field effect transistors may have planar gates, also known as planar-gate-type field effect transistors, or trench gates, also known as trench-gate-type field effect transistors. Trench-gate-type field effect transistors may be advantageous at least in some aspects. For instance, trench-gate-type field effect transistors generally have a lower on-resistance, also referred to as "Ron", and a higher current density, than planar-gate-type field effect transistors.

However, trench-gate-type field effect transistors are prone to damage and/or failure, e.g., due to a relatively strong electric field at the bottom of the trench gates. Such damage and/or failure may be caused by rupture of an insulation material, e.g., dielectric material, e.g., a metal oxide, arranged inside the trench gates, and/or thermal stress.

Moreover, at least most trench-gate-type field effect transistors known from the prior art have a relatively thin layer of dielectric material inside the trench gates to achieve a relatively low on-resistance (Ron), which is considered to be one of the main advantages of trench-gate-type field effect transistors, as discussed above. However, providing a relatively thin layer of dielectric material, compared with thicker layers of dielectric material, may increase the likelihood of damage to and/or failure of the trench-gate-type field effect transistors.

Moreover, providing a relatively thin layer of dielectric material may make the dielectric material more prone to failure due to defects, e.g., inherent defects, such as within one or more materials of the transistors and/or during manufacturing. For instance, the thickness of the layer of dielectric material may vary in each transistor, e.g., within each trench gate, and/or between one transistor and another transistor. For instance, inconsistencies along a surface on which the layer of dielectric material is applied, e.g., due to defects, surface roughness, etc., may cause the thickness of the layer of dielectric material to vary. Moreover, the inconsistencies may also be caused during manufacturing. Such inconsistencies may be compensated by providing thicker layers of dielectric material, which however undesirably increase the on-resistance (Ron) of the transistor. For instance, the on-resistance (Ron) of the transistor may generally increase linearly with an increasing thickness of the layer of dielectric material, whereas the reliability of the transistor increases exponentially with an increasing thickness of the layer of dielectric material. Thus, increasing the reliability and reducing the on-resistance (Ron) of trench-gate-type field effect transistors are countervailing effects at least with respect to the thickness of the layers of dielectric material.

However, the above-identified aspects have not, or at least not sufficiently, been addressed in the prior art. Thus, there is a need to improve the field transistor devices known from the prior art.

It is therefore an object of the present invention to provide an improved field effect transistor, in particular by providing improvement to one or more of the above-identified aspects.

The above-identified object is achieved by a trench-gate-type field effect transistor device according to a first aspect of the present disclosure, as defined by the features of claim 1. Preferred embodiments are defined by the features of the dependent claims, respectively.

Various exemplary embodiments of the present disclosure disclosed herein are directed to providing features that will become readily apparent by reference to the following description when taken in conjunction with the accompanying drawings. In accordance with various embodiments, exemplary devices are disclosed herein. It is understood, however, that these embodiments are presented by way of example and not limitation, and it will be apparent to those of ordinary skill in the art who read the present disclosure that various modifications to the disclosed embodiments can be made while remaining within the scope of the present disclosure.

Thus, the present disclosure is not limited to the exemplary embodiments and applications described and illustrated herein. Additionally, the specific order and/or hierarchy of steps in the methods disclosed herein are merely exemplary approaches. Based upon design preferences, the specific order or hierarchy of steps of the disclosed methods or processes can be re-arranged while remaining within the scope of the present disclosure. Thus, those of ordinary skill in the art will understand that the methods and techniques disclosed herein present various steps or acts in a sample order, and the present disclosure is not limited to the specific order or hierarchy presented unless expressly stated otherwise.

The trench-gate-type field effect transistor device may be configured as a metal oxide semiconductor field effect transistor, also known as MOSFET. The trench-gate-type field effect transistor device may include at least one main body which is at least partially made of silicon carbide. In other words, the trench-gate-type field effect transistor device may be configured as a silicon carbide metal oxide semiconductor field effect transistor, also known as SiC MOSFET. Silicon carbide (SiC) transistor devices have developed rapidly in recent years, in particular due to their material advantages, e.g., compared with silicon transistor devices, such as an improved applicability with high voltage, high frequency, high temperature, and high-power density.

The trench-gate-type field effect transistor device may include at least two gate trenches which may extend at least partially into the main body. The gate trenches may be configured to at least partially receive at least one electrode made at least partially of an electrically conductive material. Each gate trench may have at least one floor section and at least two side wall sections. Each side wall section may have a lower portion extending from the floor section and an upper portion extending from the lower portion.

The trench-gate-type field effect transistor device may include at least one layer of dielectric material which may cover the floor section and the side wall sections of each of the gate trenches. In other words, the layer(s) of dielectric material may at least partially separate, preferably completely separate, the electrode which is received at least partially in the respective gate trench and the main body. Hence, the layer(s) of dielectric material may at least partially, preferably completely, electrically insulate the electrode from the main body.

A thickness of the layer of dielectric material may be greater along the floor section and the lower portions of the side wall sections than along at least one reduced thickness section of at least a first gate trench of the gate trenches.

A "thickness" of a layer of dielectric material within the context of the present disclosure may refer to a dimension of the respective layer which extends substantially perpendicularly to a surface on which the respective layer is arranged, e.g., a surface of the main body within the gate trench(es).

The reduced thickness section may be provided on the side wall section of the side wall sections of the first gate trench which is arranged towards a second gate trench of the gate trenches which is adjacent to the first gate trench. The reduced thickness section may extend along the upper portion of the side wall section of the first gate trench.

Thus, providing a thicker layer of dielectric material along the floor section and the lower portions of the side wall sections than along the reduced thickness section(s) may reduce the intensity of the electrical filed at the thicker layer section(s) and/or may reduce the risk of failure of the dielectric material. Moreover, this may may reduce a gate-drain capacitance of the transistor device. This may increase a switching speed of the transistor device and/or may improve efficiency of the transistor device.

Moreover, providing the reduced thickness section(s) may reduce the on-resistance ("Ron") of the transistor device, e.g., by arranging a conductor channel, which is formed during on-state conduction of the transistor device and through which a current flows in the on-state of the field transistor, along the reduced thickness section(s), while minimizing the risk of failure of the dielectric material. In other words, the reduced thickness section(s) may extend at least partially along the conductor channel. Hence, a thicker layer of dielectric material may be provided along sections of the trench(es) in which a conductor channel is not formed. Thus, at least one conductor channel may be provided at the reduced thickness section on the side wall section of the side wall sections of the first gate trench which is arranged towards a second gate trench of the gate trenches which is adjacent to the first gate trench. In other words, at least one conductor channel may be provided partially between the gate trenches, since at least one reduced thickness section is arranged at least partially between the gate trenches. Thus, the configuration described above may strike a balance, or at least provide an improved balance, between reliability and relatively low on-resistance (Ron) of the transistor device.

Furthermore, the configuration described herein may allow a saturation current to be reduced by utilising only one trench sidewall channel for electron conduction. Thus, an improved trade-off between a relatively low on-resistance and an acceptable short-circuit safe operating area (SCSOA) may be achieved.

The conductor channel is often also referred to as a semiconductor channel, FET channel or MOSFET channel in the case of a MOSFET device. A further conductor channel may be arranged at least partially along a side wall section of at least one of the gate trenches which faces away from the other of the gate trenches, e.g., along a further reduced thickness section of the respective side wall section, as described further below. This may provide at least two conductor channels which are arranged relatively close to each other.

The transistor device may be configured as a dual gate trench device, i.e., with exactly two gate trenches. Alternatively, the transistor device may include more than two gate trenches.

The electrode is preferably made of metal and/or polycrystalline silicone, preferably doped polycrystalline silicone. In other words, the gate trenches may be at least partially filled with metal and/or polycrystalline silicone to provide the electrode.

The main body may include a plurality of layers. Alternatively, the main body may be a single integrally formed piece of material. The main body may include a plurality of doped regions or inserts integrated within the main body, as described further below in detail.

The thickness of the layer of dielectric material along the side wall section of the at least two side wall sections which is opposite from the side wall section, which has the reduced thickness section, of at least the first gate trench may be substantially constant. Alternatively, or additionally, the thickness of the layer of dielectric material along the side wall section of the at least two side wall sections which is opposite from the side wall section, which has the reduced thickness section, of at least the first gate trench may be in a range from 0.15 µm to 1 µm, preferably in a range from 0.15 µm to 0.3 µm. This may achieve a relatively low on-resistance (Ron), while limiting the risk of damage and/or failure of the dielectric material, in particular along a conductor channel which may be provided at the reduced thickness section. In other words, this may strike a balance between striving towards a relatively low on-resistance (Ron) and limiting the risk of damage and/or failure of the dielectric material, particularly along a conductor channel which may be provided at the reduced thickness section.

The thickness of the layer of dielectric material along the floor section and the lower portions of the side wall sections may be substantially constant. Alternatively, or additionally, the thickness of the layer of dielectric material along the floor section and the lower portions of the side wall sections may be in a range from 0.15 µm to 1 µm. This may limit the risk of damage and/or failure of the dielectric material along the floor section and the lower portions of the side wall sections. The floor section and the lower portions of the side wall sections may be void of a conductor channel. Thus, providing a relatively thin layer of dielectric material along the floor section and the lower portions of the side wall sections may be less important and/or less desirable, e.g., than at a conductor channel. In other words, limiting the risk of damage and/or failure of the dielectric material, e.g., by providing a thicker layer of dielectric material, along the floor section and the lower portions of the side wall sections may be more beneficial than providing a layer of dielectric material which is as thin as possible along the floor section and the lower portions of the side wall sections.

The thickness of the layer of dielectric material along the reduced thickness section may be substantially constant. Alternatively, or additionally, the thickness of the layer of dielectric material along the reduced thickness section may be in a range from 0.04 µm to 0.08 µm. This may further reduce the on-resistance (Ron), while maintaining the risk of damage and/or failure of the dielectric material within a reasonable and/or manageable range, in particular since a size and/or region of the reduced thickness section along the layer of dielectric material may be limited, e.g., to the upper portion of the side wall section of the first gate trench arranged towards the second gate trench.

The thickness of the layer of dielectric material along the bottom and the lower portions of the side wall sections may be in a range from 0.15 µm to 0.3 µm and the thickness of the layer of dielectric material along the reduced thickness section may be in a range from 0.04 µm to 0.08 µm. This may achieve a relatively low on-resistance (Ron), while limiting the risk of damage and/or failure of the dielectric material, in particular along a conductor channel which may be provided at the reduced thickness section(s). In other words, this may strike a balance, or at least an improved balance, between striving towards a relatively low on-resistance (Ron) and limiting the risk of damage and/or failure of the dielectric material, particularly along a conductor channel which may be provided at the reduced thickness section(s).

At least one of the gate trenches, preferably at least the first gate trench, may extend into the main body by a gate trench depth which is preferably in a range from 0.5 µm to 10 µm, more preferably from 1 µm to 8 µm, more preferably from 1 µm to 6 µm, more preferably from 1 µm to 5 µm, more preferably from 1 µm to 4 µm, more preferably from 1.5 µm to 3 µm. The gate trench depth, within the context of the present disclosure, includes a thickness of the layer of dielectric material at the floor section of the gate trench.

The reduced thickness section may extend along the gate trench depth by a distance which is in a range from 0.1 µm to 5 µm, more preferably from 0.2 µm to 4.5 µm, more preferably from 0.2 µm to 4 µm, more preferably from 0.2 µm to 3.5 µm, more preferably from 0.2 µm to 3 µm, more preferably from 0.2 µm to 2.5 µm, more preferably from 0.2 µm to 2 µm, more preferably from 0.2 µm to 1.5 µm, more preferably from 0.2 µm to 1 µm, more preferably from 0.2 µm to 0.9 µm, more preferably from 0.2 µm to 0.8 µm, more preferably from 0.2 µm to 0.7 µm, more preferably from 0.3 µm to 0.6 µm, more preferably from 0.4 µm to 0.6 µm. The above-identified values may limit the risk of damage and/or failure of the dielectric material along the reduced thickness section, while achieving a relatively low on-resistance (Ron), in particular along a conductor channel which may be provided at the reduced thickness section.

The lower portion of the side wall section(s) which include(s) the reduced thickness section may extend along the gate trench depth by a distance which is in a range from 0.1 µm to 5 µm, more preferably from 0.2 µm to 4.5 µm, more preferably from 0.2 µm to 4 µm, more preferably from 0.2 µm to 3.5 µm, more preferably from 0.2 µm to 3 µm, more preferably from 0.2 µm to 2.5 µm, more preferably from 0.2 µm to 2 µm, more preferably from 0.2 µm to 1.5 µm, more preferably from 0.2 µm to 1 µm, more preferably from 0.2 µm to 0.9 µm, more preferably from 0.2 µm to 0.8 µm, more preferably from 0.3 µm to 0.8 µm. The above-identified values may limit the risk of damage and/or failure of the dielectric material, while achieving a relatively low on-resistance (Ron), in particular along a conductor channel which may be provided at the reduced thickness section.

At least one of the gate trenches, preferably at least the first gate trench, may have a maximum trench width, which preferably extends in a direction which is substantially perpendicular to the gate trench depth. The maximum trench width may be in a range from 0.5 µm to 10 µm, more preferably 0.5 µm to 8 µm, more preferably 0.5 µm to 7 µm, more preferably 0.5 µm to 6 µm, more preferably 0.5 µm to 5 µm, more preferably 0.75 µm to 5 µm, more preferably 1 µm to 5 µm, more preferably 1 µm to 4.5 µm, more preferably 1 µm to 4 µm, more preferably 1.5 µm to 3.5 µm, more preferably 1.5 µm to 3 µm. The trench width may be uniform or non-uniform along the respective gate trench(es), in particular along a gate trench depth, i.e., a depth by which the gate trench extends into the main body.

The main body may include at least one n type region, preferably at least one n- type region.

The lower portion of the side wall section(s) which include(s) the reduced thickness section may be in contact with the n type region. The n type region is defined as being made of an n type semiconductor material, e.g., by doping the n type region with an electron donor element, e.g., during manufacturing. An n type dopant, such as phosphorus and/or arsenic and/or antimony, may be used to provide the n type region. An n+ type region refers to a region which is defined as a highly doped region, i.e., to a larger degree than an n type region, i.e., a region which has a higher concentration of the respective n type dopant(s) than an n type region. An n- type region refers to a region which is defined as a relatively low doped region, i.e., to a lesser degree than an n type region, i.e., a region which has a lower concentration of the respective n type dopant(s) than an n type region

The main body may be void of a p type region, in particular a p+ type region, in one or more sections of the main body which are in contact with and/or adjacent to the lower portions of the side wall sections. Alternatively, or additionally, the main body may be void of a p type region, preferably a p+ type region, in one or more sections of the main body which extend between the gate trenches. A p type region is defined as being made of a p type semiconductor material, e.g., by doping the p type region with an electron acceptor element, e.g., during manufacturing. A p type dopant, such as boron and/or gallium and/or aluminium, may be used to provide the p type region. A p+ type region refers to a region which is defined as a highly doped region, i.e., to a larger degree than a p type region, i.e., a region which has a higher concentration of the respective p type dopant(s) than a p type region.

Preferably, the above-identified one or more sections of the main body which are void of a p type region may be entirely void of any p type dopant. In other words, the above-identified one or more sections of the main body which are void of a p type region may have a concentration of any p type dopant of 0.

Trench-gate-type field effect transistors which have asymmetric channels have been proposed in the prior art to offer an enhanced protection of the relatively thin layer of dielectric material along the gate trench bottom region against the relatively strong electric field.

Such asymmetric channel designs provide a conductor channel only on one trench side wall during current conduction. The second trench gate side wall is therefore not used for current conduction in the on-state. To achieve such an effect, the respective trench-gate-type field effect transistor include a high energy (MeV) shield p+ implant on the side of the trench gate that is not used for current conduction. The said p+ implant extends to the bottom of the gate trench.

However, such a configuration may increase a distance between adjacent trench gates which may reduce and/or limit a closeness, and thus a packing density of trench gates in the respective trench-gate-type field effect transistors, in particular due to a junction-gate field-effect transistor (JFET) resistance which may occur between neighbouring p+ areas. The (JFET) resistance may increase with a reduction in a distance between neighbouring p+ areas. Thus, omitting a p/p+ type region along the lower portions of the side wall sections may eliminate, or at least reduce, the JFET resistance or effect, which may allow a distance between the trench gates to be reduced, i.e., the trench gates may be arranged closer together. This may reduce the on-resistance (Ron) of the transistor device and/or may increase the efficiency of the transistor device. In particular, the transistor device disclosed herein may be specifically configured, e.g., by providing a certain thickness of the layer of the dielectric material along the area(s) void of the p/p+ type region, such that drawbacks of omitting the p/p+ type region may be eliminated, or at least reduced to a reasonable and/or manageable degree.

The device may further include at least one source section, preferably made of metal, which is attached to the main body adjacent to the gate trenches.

The device may further include at least one drain section, preferably made of an n type, preferably an n+ type, semiconductor material, which is attached to the main body, preferably on a section of the main body which is arranged opposite to the source section.

The dielectric material may be an oxide, preferably an oxide of silicon, preferably silicon dioxide.

The main body may include at least one n+ region which is in contact with and/or adjacent to the upper portions of the side wall section of at least one of the gate trenches. The n+ region may be arranged at least partially between the gate trenches. Preferably, a p type region may be provided adjacent to and/or in contact with the n+ region. This may increase a switching speed of the transistor device, e.g., by weakening a PN diode of the transistor device, e.g., provided within the main body, e.g., via an N- (or n-base) type region and a p or p+ type region, e.g., a deep p+ type region of the main body.

The second gate trench may have at least one layer of dielectric material which has a thickness which is greater along the floor section and the lower portions of the side wall sections than along at least one second reduced thickness section of the second gate trench. The second reduced thickness section may be provided on the side wall section of the side wall sections of the second gate trench which is arranged away from the first gate trench. The second reduced thickness section may extend along the upper portion of the side wall section of the second gate trench. Thus, a further conductor channel may be provided along the second reduced thickness section of the second gate trench.

The first gate trench may be configured such that the electrode, when the electrode is received in the first gate trench, has at least one protrusion which may extend towards the side wall section of the first gate trench, along which the reduced thickness section is arranged. The protrusion may fill one or more voids which may be caused by the reduced thickness of the layer of dielectric material along the reduced thickness section. This may allow a wall of the main body along the reduced thickness section to be configured to be substantially linear, i.e., straight and/or continuous. This may facilitate the manufacturing process for manufacturing the transistor device.

The object mentioned at the beginning is also solved by a method of manufacturing a trench-gate-type field effect transistor device, preferably a trench-gate-type field effect transistor device according to any of the configurations described herein. The features, embodiments, and advantages described above with respect to the trench-gate-type field effect transistor device apply to the method accordingly.

The method may include:
(a) providing at least one main body which is made of silicon carbide.

The method may further include:
(b) providing at least two gate trenches which may extend at least partially into the main body and which may be configured to receive at least one electrode made at least partially of an electrically conductive material, each gate trench may have at least one floor section and at least two side wall sections, each side wall section may have a lower portion extending from the floor section and an upper portion extending from the lower portion.

The method may further include:
(c) covering the floor section and the side wall sections of each of the gate trenches with at least one layer of dielectric material such that a thickness of the layer of dielectric material may be greater along the floor section and the lower portions of the side wall sections than along at least one reduced thickness section of at least a first gate trench of the two gate trenches.

The reduced thickness section may be provided on the side wall section of the side wall sections of the first gate trench which is arranged towards a second gate trench of the gate trenches which is adjacent to the first gate trench. The reduced thickness section may extend along the upper portion of the side wall section of the first gate trench.

In step (c), the dielectric material may be applied to the floor section and the side wall sections of each of the gate trenches and/or a portion of the applied dielectric material may be removed at the lower portions of the side wall section(s), preferably by etching the dielectric material to be removed, to provide the reduced thickness section. This may provide a relatively inexpensive and/or simpler method of manufacturing the transistor device.

The dielectric material may be removed by applying at least one acid solution to the dielectric material. The at least one acid solution may include at least one hydrofluoric acid solution, preferably at least one hydrofluoric acid solution which includes hydrogen fluoride gas and a liquid, preferably water. The acid solution may have a 50:1 concentration of hydrogen fluoride gas to liquid, e.g., water. This may provide a relatively reliable, efficient, and/or effective way of manufacturing the transistor device, in particular of providing the reduced thickness section.

At least one protective material, preferably at least one photoresist, may be applied to one or more surfaces of the dielectric material. The protective material may be omitted along at least a section of the dielectric material in which the reduced thickness section is to be provided prior to removing the applied dielectric material.

In step (b), the gate trenches may be etched into the main body, preferably by applying at least one acid solution to the main body.

One or more doped regions and/or doped implants may be provided to/in the main body, preferably prior to etching. The one or more doped regions and/or doped implants may be masked prior to etching, e.g., to avoid removal thereof.

The following list of aspects provides alternative and/or further features of the invention:
1. A transistor device, in particular a trench-gate-type field effect transistor device, including:
   at least one main body, which is preferably at least partially made of silicon carbide;
   at least two gate trenches which extend at least partially into the main body and which are configured to at least partially receive at least one electrode made at least partially of an electrically conductive material, each gate trench having at least one floor section and at least two side wall sections, each side wall section having a lower portion extending from the floor section and an upper portion extending from the lower portion; and
   at least one layer of dielectric material covering the floor section and the side wall sections of each of the gate trenches, wherein a thickness of the layer of dielectric material is greater along the floor section and the lower portions of the side wall sections than along at least one reduced thickness section of at least a first gate trench of the gate trenches, wherein the reduced thickness section is provided on the side wall section of the side wall sections of the first gate trench which is arranged towards a second gate trench of the gate trenches which is adjacent to the first gate trench, and wherein the reduced thickness section extends along the upper portion of the side wall section of the first gate trench.
2. The device according to aspect 1, wherein the thickness of the layer of dielectric material along the side wall section of the at least two side wall sections which is opposite from the side wall section, which has the reduced thickness section, of at least the first gate trench is substantially constant, preferably in a range from 0.15 µm to 1 µm, more preferably in a range from 0.15 µm to 0.3 µm.
3. The device according to aspect 1 or 2, wherein the thickness of the layer of dielectric material along the floor section and the lower portions of the side wall sections is substantially constant, preferably in a range from 0.15 µm to 1 µm.
4. The device according to any of the preceding aspects, wherein the thickness of the layer of dielectric material along the reduced thickness section is substantially constant, preferably in a range from 0.04 µm to 0.08 µm.
5. The device according to any of the preceding aspects, wherein the thickness of the layer of dielectric material along the bottom and the lower portions of the side wall sections is in a range from 0.15 µm to 0.3 µm and the thickness of the layer of dielectric material along the reduced thickness section is in a range from 0.04 µm to 0.08 µm.
6. The device according to any of the preceding aspects, wherein at least one of the gate trenches, preferably at least the first gate trench, extends into the main body by a gate trench depth which is preferably in a range from 0.5 µm to 10 µm, more preferably from 1 µm to 8 µm, more preferably from 1 µm to 6 µm, more preferably from 1 µm to 5 µm, more preferably from 1 µm to 4 µm, more preferably from 1.5 µm to 3 µm.
7. The device according to aspect 6, wherein the reduced thickness section extends along the gate trench depth by a distance which is in a range from 0.1 µm to 5 µm, more preferably from 0.2 µm to 4.5 µm, more preferably from 0.2 µm to 4 µm, more preferably from 0.2 µm to 3.5 µm, more preferably from 0.2 µm to 3 µm, more preferably from 0.2 µm to 2.5 µm, more preferably from 0.2 µm to 2 µm, more preferably from 0.2 µm to 1.5 µm, more preferably from 0.2 µm to 1 µm, more preferably from 0.2 µm to 0.9 µm, more preferably from 0.2 µm to 0.8 µm, more preferably from 0.2 µm to 0.7 µm, more preferably from 0.3 µm to 0.6 µm, more preferably from 0.4 µm to 0.6 µm.
8. The device according to aspect 6 or 7, wherein the lower portion of the side wall section(s) which include(s) the reduced thickness section extends along the gate trench depth by a distance which is in a range from 0.1 µm to 5 µm, more preferably from 0.2 µm to 4.5 µm, more preferably from 0.2 µm to 4 µm, more preferably from 0.2 µm to 3.5 µm, more preferably from 0.2 µm to 3 µm, more preferably from 0.2 µm to 2.5 µm, more preferably from 0.2 µm to 2 µm, more preferably from 0.2 µm to 1.5 µm, more preferably from 0.2 µm to 1 µm, more preferably from 0.2 µm to 0.9 µm, more preferably from 0.2 µm to 0.8 µm, more preferably from 0.3 µm to 0.8 µm.
9. The device according to any of aspects 6 to 8, wherein at least one of the gate trenches, preferably at least the first gate trench, has a maximum trench width, which preferably extends in a direction which is substantially perpendicular to the gate trench depth, the maximum trench width being in a range from 0.5 µm to 10 µm, more preferably 0.5 µm to 8 µm, more preferably 0.5 µm to 7 µm, more preferably 0.5 µm to 6 µm, more preferably 0.5 µm to 5 µm, more preferably 0.75 µm to 5 µm, more preferably 1 µm to 5 µm, more preferably 1 µm to 4.5 µm, more preferably 1 µm to 4 µm, more preferably 1.5 µm to 3.5 µm, more preferably 1.5 µm to 3 µm.
10. The device according to any of the preceding aspects, wherein the main body includes at least one n type region, preferably at least one n- type region, preferably wherein the lower portion of the side wall section(s) which include(s) the reduced thickness section is in contact with the n type region.
11. The device according to any of the preceding aspects, wherein the main body is void of a p type region, preferably a p+ type region:
   in one or more sections of the main body which are in contact with and/or adjacent to the lower portions of the side wall sections;
      and/or
   in one or more sections of the main body which extend between the gate trenches.
12. The device according to any of the preceding aspects, further including at least one source section, preferably made of metal, which is attached to the main body adjacent to the gate trenches.
13. The device according to any of the preceding aspects, further including at least one drain section, preferably made of an n type, preferably an n+ type, semiconductor material, which is attached to the main body, preferably on a section of the main body which is arranged opposite to the source section.
14. The device according to any of the preceding aspects, wherein the dielectric material is an oxide, preferably an oxide of silicon, preferably silicon dioxide.
15. The device according to any of the preceding aspects, wherein the main body includes at least one n+ region which is in contact with and/or adjacent to the upper portions of the side wall section of at least one of the gate trenches, wherein the n+ region is arranged at least partially between the gate trenches.
16. The device according to any of the preceding aspects, wherein the second gate trench has at least one layer of dielectric material which has a thickness which is greater along the floor section and the lower portions of the side wall sections than along at least one second reduced thickness section of the second gate trench, wherein the second reduced thickness section is provided on the side wall section of the side wall sections of the second gate trench which is arranged away from the first gate trench, and wherein the second reduced thickness section extends along the upper portion of the side wall section of the second gate trench.
17. The device according to any of the preceding aspects, wherein the first gate trench is configured such that the electrode, when the electrode is received in the first gate trench, has at least one protrusion which extends towards the side wall section of the first gate trench, along which the reduced thickness section is arranged.
18. A method of manufacturing a transistor device, preferably a transistor device according to any of the preceding aspects, preferably a trench-gate-type field effect transistor device, the method including:
   (a) providing at least one main body which is made of silicon carbide;
   (b) providing at least two gate trenches which extend at least partially into the main body and which are configured to receive at least one electrode made at least partially of an electrically conductive material, each gate trench having at least one floor section and at least two side wall sections, each side wall section having a lower portion extending from the floor section and an upper portion extending from the lower portion; and
   (c) covering the floor section and the side wall sections of each of the gate trenches with at least one layer of dielectric material such that a thickness of the layer of dielectric material is greater along the floor section and the lower portions of the side wall sections than along at least one reduced thickness section of at least a first gate trench of the two gate trenches, wherein the reduced thickness section is provided on the side wall section of the side wall sections of the first gate trench which is arranged towards a second gate trench of the gate trenches which is adjacent to the first gate trench, and wherein the reduced thickness section extends along the upper portion of the side wall section of the first gate trench.
19. The method according to aspect 18, wherein, in step (c), the dielectric material is applied to the floor section and the side wall sections of each of the gate trenches and a portion of the applied dielectric material is removed at the lower portions of the side wall section(s), preferably by etching the dielectric material to be removed, to provide the reduced thickness section.
20. The method according to aspect 19, wherein the dielectric material is removed by applying at least one acid solution to the dielectric material, preferably wherein the at least one acid solution includes at least one hydrofluoric acid solution, preferably at least one hydrofluoric acid solution which includes hydrogen fluoride gas and a liquid, preferably water.
21. The method according to aspect 19 or 20, wherein at least one protective material, preferably at least one photoresist, is applied to one or more surfaces of the dielectric material, wherein the protective material is omitted along at least a section of the dielectric material in which the reduced thickness section is to be provided prior to removing the applied dielectric material.
22. The method according to any of aspects 18 to 21, wherein, in step (b), the gate trenches are etched into the main body, preferably by applying at least one acid solution to the main body.

Embodiments of the present invention are further elucidated below with reference to the figures. The figures are schematic drawings and as such may not show all details of the systems and their components. Particularly, the drawings are not necessarily to scale and the shown dimensions are only exemplary and may vary. The drawings illustrate exemplary embodiments to provide a thorough understanding of the present invention. The drawings are not intended to limit the scope of the invention, which is defined by the appended claims and is to include the equivalents thereof.
- Fig. 1: shows, in a schematic cross-sectional view, a transistor device according to an embodiment of the present disclosure;
- Fig. 2: shows, in a schematic cross-sectional view, a transistor device according to a further embodiment of the present disclosure;
- Fig. 3: shows, in a schematic cross-sectional view, a portion of a method of manufacturing a transistor device according to an embodiment of the present disclosure;
- Fig. 4: shows, in a schematic cross-sectional view, a portion of a method of manufacturing a transistor device according to an embodiment of the present disclosure;
- Fig. 5: shows, in a schematic cross-sectional view, a portion of a method of manufacturing a transistor device according to an embodiment of the present disclosure;
- Fig. 6: shows, in a schematic cross-sectional view, a portion of a method of manufacturing a transistor device according to an embodiment of the present disclosure;
- Fig. 7: shows, in a schematic cross-sectional view, a portion of a method of manufacturing a transistor device according to an embodiment of the present disclosure;
- Fig. 8: shows, in a schematic cross-sectional view, a portion of a method of manufacturing a transistor device according to an embodiment of the present disclosure;
- Fig. 9: shows, in a schematic cross-sectional view, a portion of a method of manufacturing a transistor device according to an embodiment of the present disclosure;
- Fig. 10: shows, in a schematic cross-sectional view, a portion of a method of manufacturing a transistor device according to an embodiment of the present disclosure;
- Fig. 11: shows, in a schematic cross-sectional view, a portion of a method of manufacturing a transistor device according to an embodiment of the present disclosure.

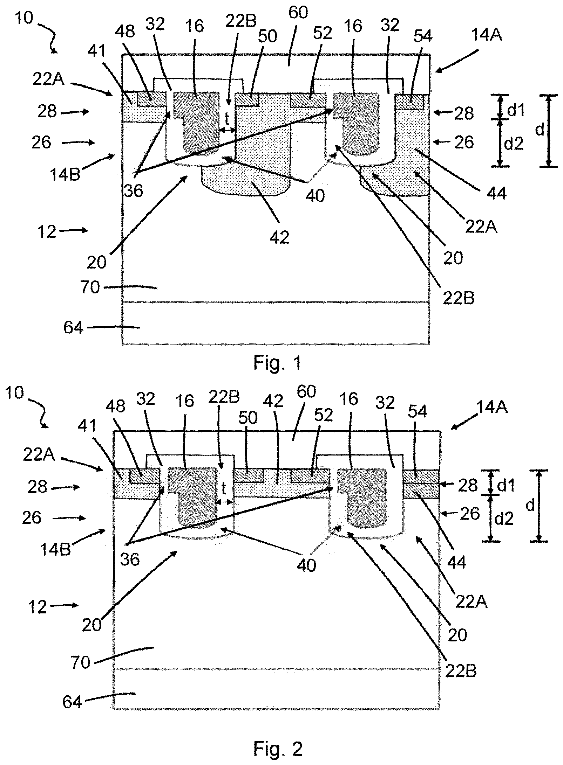

Fig. 1 shows, in a schematic cross-section view, a transistor device 10, which may be configured as a trench-gate-type field effect transistor device, which may include at least one main body 12. The main body 12 may be at least partially made of silicon carbide.

The transistor device 10 may include at least two gate trenches 14A, 14B which extend at least partially into the main body 12. The gate trenches 14A, 14B may at least partially house, or be configured to at least partially receive, at least one electrode 16 made at least partially of an electrically conductive material. Each gate trench 14A, 14B may have at least one floor section 20 and at least two side wall sections 22A, 22B. Each side wall section 22A, 22B may have a lower portion 26 extending from the floor section 20 and an upper portion 28 extending from the lower portion 26.

The transistor device 10 may further include at least one layer of dielectric material 32 covering the floor section 20 and the side wall sections 22A, 22B of each of the gate trenches 14A, 14B. A thickness of the layer of dielectric material 32 is indicated by the reference sign "t" in Fig. 1 in an exemplary manner. The thickness of the layer of dielectric material 32 may be greater along the floor section 20 and the lower portions 26 of the side wall sections 22A, 22B than along at least one reduced thickness section 36 of at least a first gate trench of the gate trenches 14A, 14B. The reduced thickness section 36 may be provided on the side wall section 22B of the side wall sections 22A, 22B of the first gate trench 14A which is arranged towards a second gate trench 14B of the gate trenches 14A, 14B which is adjacent to the first gate trench 14A. The reduced thickness section 36 may extend along the upper portion 28 of the side wall section 22A, 22B of the first gate trench 14A. The section(s) along the floor section 20 and the lower portions 26 of the side wall sections 22A, 22B which have/has a greater thickness of the layer of dielectric material 32 than along the reduced thickness section(s) 36 is indicated by the reference sign 40 in the Figs.

The second gate trench 14B may have at least one second reduced thickness section 36 on the side wall section 22A of the side wall sections 22A, 22B of the second gate trench 14B which is arranged away from the first gate trench 14A. The second reduced thickness section 36 may extend along the upper portion 28 of the side wall section 22A of the second gate trench 14B.

The transistor device 10 may include one or more p type regions. For instance, at least one p type region 41, also referred to as a p well, may be arranged at least partially along the side wall section 22A of the second gate trench 14B which faces away from the first gate trench 14A. At least one further p type region 42, in particular a p+ type region, in particular a deep p+ type region, may be arranged at least partially between the gate trenches 14A, 14B. The p type region 42 may extend to or beyond the floor section 20 of at least one of the gate trenches 14A, 14B. At least one further p type region 44, in particular a p+ type region, in particular a deep p+ type region, may be arranged at least partially along the side wall section 22A of the first gate trench 14A which faces away from the second gate trench 14B. The p type region 42 may extend to or beyond the floor section 20 of the first gate trench 14A.

The transistor device 10 may include one or more n type regions. For instance, at least one n type region 48, in particular at least one n+ type region, may be arranged at least partially along the side wall section 22A of the second gate trench 14B which faces away from the first gate trench 14A, in particular at least partially along the upper portion 28 of the side wall section 22A of the second gate trench 14B. Alternatively, or additionally, at least one n type region 50, in particular at least one n+ type region, may be arranged at least partially along the side wall section 22B of the second gate trench 14B which faces the first gate trench 14A, in particular at least partially along the upper portion 28 of the side wall section 22B of the second gate trench 14B. Alternatively, or additionally, at least one n type region 52, in particular at least one n+ type region, may be arranged at least partially along the side wall section 22B of the first gate trench 14A which faces the second gate trench 14B, in particular at least partially along the upper portion 28 of the side wall section 22B of the first gate trench 14A. Alternatively, or additionally, at least one n type region 54, in particular at least one n+ type region, may be arranged at least partially along the side wall section 22A of the first gate trench 14A which faces away from the second gate trench 14B, in particular at least partially along the upper portion 28 of the side wall section 22A of the first gate trench 14A.

The transistor device 10 may include at least one source section 60, preferably made of metal, which is attached to the main body 12 proximate or adjacent to the gate trenches 14A, 14B.

The transistor device 10 may include at least one drain section 64, preferably made of an n type, preferably an n+ type, semiconductor material, which may be attached to the main body 12, preferably on a section of the main body 12 which is arranged opposite to the source section 60.

The main body 12 may include at least one n type region 70, preferably at least one n- type region, which is in contact with the lower portion 26 of the side wall section(s) 22A, 22B which include(s) the reduced thickness section 36.

At least one of the gate trenches 14A, 14B may extend into the main body 12 by a gate trench depth d. The reduced thickness section 36 may extend along the gate trench depth d by a distance d1 which may be in a range from 0.1 µm to 5 µm. The lower portion 26 of the side wall section(s) 22A, 22B which include(s) the reduced thickness section 36 may extend along the gate trench depth d by a distance d2 which may be in a range from 0.1 µm to 5 µm.

Fig. 2 shows a modified configuration of the transistor device 10 shown in Fig. 1. In particular, the transistor device 10, in particular the main body 12 of the transistor device 10, of Fig. 2 may be void of a p type region, preferably a p+ type region, in one or more sections of the main body 12 which are in contact with and/or adjacent to the lower portions 26 of the side wall sections 22A, 22B and/or in one or more sections of the main body 12 which extend between the gate trenches 14A, 14B.

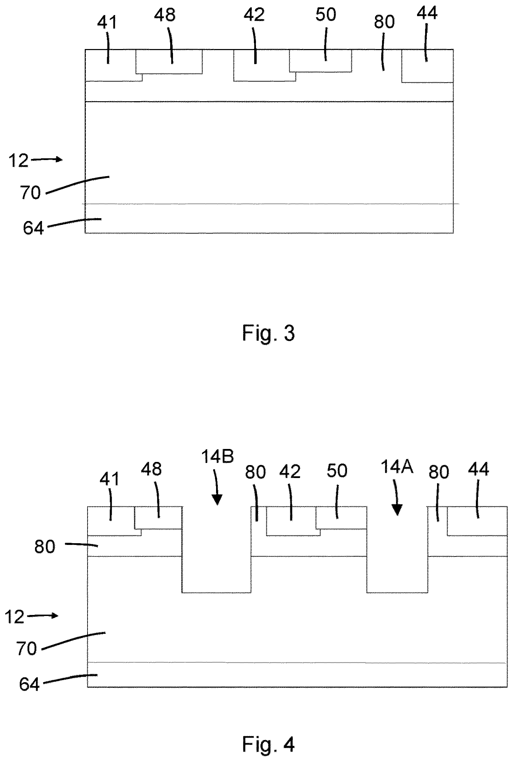

Figs. 3 to 11 show at least a portion of a method of manufacturing a trench-gate-type field effect transistor device, in particular a trench-gate-type field effect transistor device 10 according to any of the configurations described herein, e.g., the transistor device 10 shown in Figs. 1 or 2.

As shown in Fig. 3, a main body 12 may be provided with one or more doped regions or implants, e.g., one or more n type regions 48, 50, in particular one or more n+ type regions 48, 50 and/or one or more n- type regions 70, and/or one or more p type regions 41, 42, 44, 80, in particular one or more p+ type regions 41, 42, 44. The doped regions or implants may be at least partially masked by one or more masking materials (not shown).

As shown in Fig. 4, one or more gate trenches 14A, 14B may be etched into the main body 12, e.g., by applying at least one acid solution to the main body 12, in particular at one or more sections in which the above-mentioned masking material(s) is/are omitted.

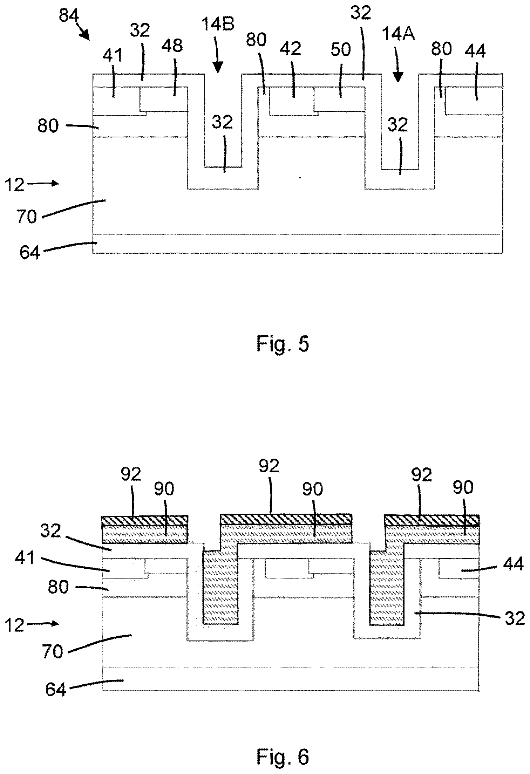

As shown in Fig. 5, at least one layer of dielectric material 32 may be applied, e.g., deposited, at least to the floor section 20 and the side wall sections 22A, 22B of each of the gate trenches 14A, 14B. The dielectric material 32 may also be applied to a top surface 84 of the main body 12, e.g., along one or more of the doped regions or implants 41, 42, 44, 48, 50.

As shown in Fig. 6, at least one layer of a protective material, e.g., at least one layer of a photoresist material 90 and/or at least one layer of a photomask 92, may be applied to one or more surfaces of the dielectric material 32. The protective material 90, 92 may be omitted along at least a section of the dielectric material 32 which is to be removed, e.g., to provide a reduced thickness section, e.g., the reduced thickness section 36 shown in Figs. 1 and 2.

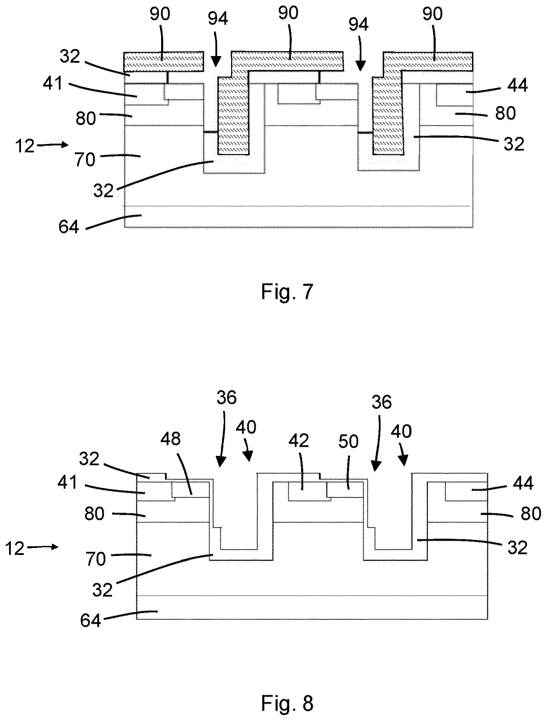

As shown in Fig. 7, one or sections of the dielectric material 32 may be removed by applying at least one removing medium 94 configured to remove the one or sections of the dielectric material 32, e.g., at least one acid solution, to the concerned section(s) of the dielectric material 32. The removing medium 94 may interact with the dielectric material 32 at the section(s) in which the protective material 90, 92 was omitted.

The removing medium 94, e.g., the at least one acid solution, may include at least one hydrofluoric acid solution, preferably at least one hydrofluoric acid solution which includes hydrogen fluoride gas and a liquid, preferably water. The removed section(s) of the dielectric material may result in one or more voids, grooves or empty spaces between sections of the dielectric material 32 and/or within the dielectric material 32.

As shown in Fig. 8, the protective material 90, 92 may be removed and at least one layer of dielectric material 32 may be applied to the section(s) in which the dielectric material was removed. The layer of dielectric material 32 which may be applied to the section(s) in which the dielectric material was removed may have a thickness which is less than a thickness of the layer(s) of dielectric material which was not removed, i.e., the dielectric material 32 which remained in Fig. 7. This may achieve at least one reduced thickness section 36 at at least a first gate trench of the gate trenches 14A, 14B. The reduced thickness section 36 may have a thickness of the layer of dielectric material 32 which is less than along the floor section 20 and the lower portions 26 of the side wall sections 22A, 22B, i.e., section 40, e.g., as shown in Figs. 1 and 2.

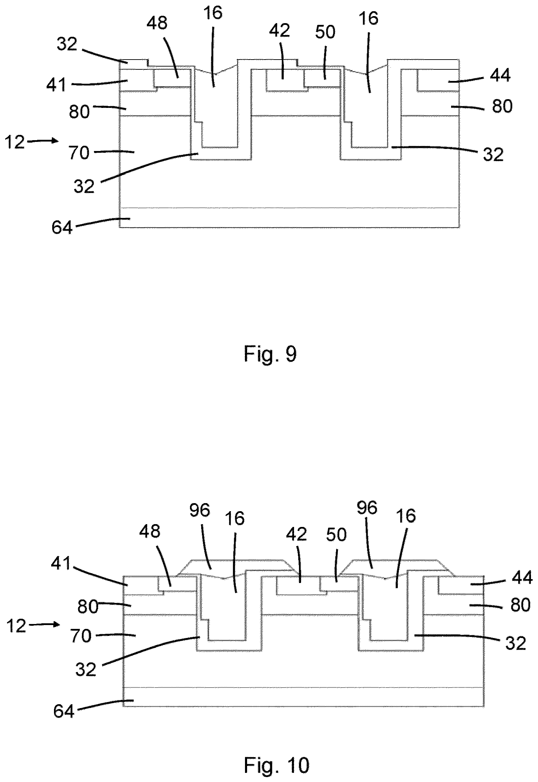

As shown in Fig. 9, an electrically conductive material, e.g., a metal and/or polycrystalline silicone, may be introduced into the gate trenches 14A, 14B to provide an electrode 16, e.g., the electrode 16 shown in Figs. 1 and 2.

As shown in Fig. 10, one or more contact materials, e.g., borophosphosilicate glass, may be applied to one or more surfaces, e.g., a top surface, and optionally etched, to provide one or more contacts 96.

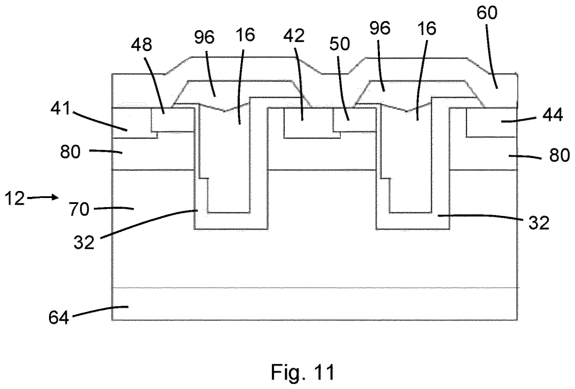

As shown in Fig. 11, a material, in particular a metal, may be applied to applied to one or more surface, e.g., a top surface, to provide one or more source section, e.g., the source section(s) 60 shown Figs. 1 and 2.

## Claims

1. A trench-gate-type field effect transistor device (10), including:
at least one main body (12) which is at least partially made of silicon carbide;
at least two gate trenches (14A, 14B) which extend at least partially into the main body (12) and which are configured to at least partially receive at least one electrode (16) made at least partially of an electrically conductive material, each gate trench (14A, 14B) having at least one floor section (20) and at least two side wall sections (22A, 22B), each side wall section (22A, 22B) having a lower portion (26) extending from the floor section (20) and an upper portion (28) extending from the lower portion (26); and
at least one layer of dielectric material (32) covering the floor section (20) and the side wall sections (22A, 22B) of each of the gate trenches (14A, 14B), wherein a thickness (t) of the layer of dielectric material (32) is greater along the floor section (20) and the lower portions (26) of the side wall sections (22A, 22B) than along at least one reduced thickness section (36) of at least a first gate trench of the gate trenches (14A, 14B), wherein the reduced thickness section (36) is provided on the side wall section of the side wall sections (22A, 22B) of the first gate trench which is arranged towards a second gate trench of the gate trenches (14A, 14B), which is adjacent to the first gate trench, and wherein the reduced thickness section (36) extends along the upper portion (28) of the side wall section of the first gate trench.

2. The device (10) according to claim 1, wherein the thickness (t) of the layer of dielectric material (32) along the side wall section of the at least two side wall sections (22A, 22B) which is opposite from the side wall section, which has the reduced thickness section (36), of at least the first gate trench is substantially constant, preferably in a range from 0.15 µm to 1 µm, more preferably in a range from 0.15 µm to 0.3 µm.

3. The device (10) according to claim 1 or 2, wherein the thickness (t) of the layer of dielectric material (32) along the floor section (20) and the lower portions (26) of the side wall sections (22A, 22B) is substantially constant, preferably in a range from 0.15 µm to 1 µm.

4. The device (10) according to any of the preceding claims, wherein the thickness (t) of the layer of dielectric material (32) along the reduced thickness section (36) is substantially constant, preferably in a range from 0.04 µm to 0.08 µm.

5. The device (10) according to any of the preceding claims, wherein the thickness (t) of the layer of dielectric material (32) along the bottom (20) and the lower portions (26) of the side wall sections (22A, 22B) is in a range from 0.15 µm to 0.3 µm and the thickness (t) of the layer of dielectric material (32) along the reduced thickness section (36) is in a range from 0.04 µm to 0.08 µm.

6. The device (10) according to any of the preceding claims, wherein at least one of the gate trenches (14A, 14B), preferably at least the first gate trench, extends into the main body (12) by a gate trench depth (d), wherein the reduced thickness section (36) extends along the gate trench depth (d) by a distance (d1) which is in a range from 0.1 µm to 5 µm, more preferably from 0.2 µm to 4.5 µm, more preferably from 0.2 µm to 4 µm, more preferably from 0.2 µm to 3.5 µm, more preferably from 0.2 µm to 3 µm, more preferably from 0.2 µm to 2.5 µm, more preferably from 0.2 µm to 2 µm, more preferably from 0.2 µm to 1.5 µm, more preferably from 0.2 µm to 1 µm, more preferably from 0.2 µm to 0.9 µm, more preferably from 0.2 µm to 0.8 µm, more preferably from 0.2 µm to 0.7 µm, more preferably from 0.3 µm to 0.6 µm, more preferably from 0.4 µm to 0.6 µm.

7. The device (10) according to any of the preceding claims, wherein at least one of the gate trenches (14A, 14B, preferably at least the first gate trench, extends into the main body (12) by a gate trench depth (d), wherein the lower portion (26) of the side wall section(s) (22A, 22B) which include(s) the reduced thickness section (36) extends along the gate trench depth (d) by a distance (d2) which is in a range from 0.1 µm to 5 µm, more preferably from 0.2 µm to 4.5 µm, more preferably from 0.2 µm to 4 µm, more preferably from 0.2 µm to 3.5 µm, more preferably from 0.2 µm to 3 µm, more preferably from 0.2 µm to 2.5 µm, more preferably from 0.2 µm to 2 µm, more preferably from 0.2 µm to 1.5 µm, more preferably from 0.2 µm to 1 µm, more preferably from 0.2 µm to 0.9 µm, more preferably from 0.2 µm to 0.8 µm, more preferably from 0.3 µm to 0.8 µm.

8. The device (10) according to any of the preceding claims, wherein the main body (12) includes at least one n type region (70), preferably at least one n- type region, wherein the lower portion (26) of the side wall section(s) (22A, 22B) which include(s) the reduced thickness section (36) is in contact with the n type region (70).

9. The device (10) according to any of the preceding claims, wherein the main body (12) is void of a p type region, preferably a p+ type region:
in one or more sections of the main body (12) which are in contact with and/or adjacent to the lower portions (26) of the side wall sections (22A, 22B);
and/or
in one or more sections of the main body (12) which extend between the gate trenches (14A, 14B).

10. The device (10) according to any of the preceding claims, wherein the main body (12) includes at least one n+ region (48, 50, 52, 54) which is in contact with and/or adjacent to the upper portions (28) of the side wall section (22A, 22B) of at least one of the gate trenches (14A, 14B), wherein the n+ region (50, 52) is arranged at least partially between the gate trenches (14A, 14B).

11. The device (10) according to any of the preceding claims, wherein the second gate trench (14B) has at least one layer of dielectric material (32) which has a thickness (t) which is greater along the floor section (20) and the lower portions (26) of the side wall sections (22A, 22B) than along at least one second reduced thickness section (36) of the second gate trench (14B), wherein the second reduced thickness section (36) is provided on the side wall section (22A) of the side wall sections (22A, 22B) of the second gate trench (14B) which is arranged away from the first gate trench (14A), and wherein the second reduced thickness section (36) extends along the upper portion (28) of the side wall section (22A) of the second gate trench (14B).

12. A method of manufacturing a trench-gate-type field effect transistor device (10), preferably a trench-gate-type field effect transistor device (10) according to any of the preceding claims, the method including:
(a) providing at least one main body (12) which is made of silicon carbide;
(b) providing at least two gate trenches (14A, 14B) which extend at least partially into the main body (12) and which are configured to receive at least one electrode (16) made at least partially of an electrically conductive material, each gate trench (14A, 14B) having at least one floor section (20) and at least two side wall sections (22A, 22B), each side wall section (22A, 22B) having a lower portion (26) extending from the floor section (20) and an upper portion (28) extending from the lower portion (26); and
(c) covering the floor section (20) and the side wall sections (22A, 22B) of each of the gate trenches (14A, 14B) with at least one layer of dielectric material (32) such that a thickness (t) of the layer of dielectric material (32) is greater along the floor section (20) and the lower portions (26) of the side wall sections (22A, 22B) than along at least one reduced thickness section (36) of at least a first gate trench (14A) of the two gate trenches (14A, 14B), wherein the reduced thickness section (36) is provided on the side wall section (22B) of the side wall sections (22A, 22B) of the first gate trench (14A) which is arranged towards a second gate trench (14B) of the gate trenches (14A, 14B) which is adjacent to the first gate trench (14A), and wherein the reduced thickness section (36) extends along the upper portion (28) of the side wall section (22B) of the first gate trench (14A).

13. The method according to claim 12, wherein, in step (c), the dielectric material (32) is applied to the floor section (20) and the side wall sections (22A, 22B) of each of the gate trenches (14A, 14B) and a portion of the applied dielectric material (32) is removed at the lower portions (26) of the side wall section(s) (22A, 22B), preferably by etching the dielectric material (32) to be removed, to provide the reduced thickness section (36).

14. The method according to claim 13, wherein the dielectric material (32) is removed by applying at least one acid solution (94) to the dielectric material, preferably wherein the at least one acid solution includes at least one hydrofluoric acid solution, preferably at least one hydrofluoric acid solution which includes hydrogen fluoride gas and a liquid, preferably water.

15. The method according to claim 13 or 14, wherein at least one protective material (90, 92), preferably at least one photoresist (90), is applied to one or more surfaces of the dielectric material (32), wherein the protective material (90, 92) is omitted along at least a section of the dielectric material (32) in which the reduced thickness section (36) is to be provided prior to removing the applied dielectric material (32).
